(19) Europäisches Patentamt
European Patent Office
Office européen des brevets

(11) EP 4 516 431 A1

(12) EUROPEAN PATENT APPLICATION
published in accordance with Art. 153(4) EPC

(43) Date of publication:
05.03.2025 Bulletin 2025/10

(51) International Patent Classification (IPC):
$B22F\ 9/24^{(2006.01)}$          $B22F\ 1/00^{(2022.01)}$
$B22F\ 1/103^{(2022.01)}$         $B22F\ 1/105^{(2022.01)}$

(21) Application number: 23796403.6

(22) Date of filing: 25.04.2023

(52) Cooperative Patent Classification (CPC):
B22F 1/00; B22F 1/103; B22F 1/105; B22F 9/24

(86) International application number:
PCT/JP2023/016355

(87) International publication number:
WO 2023/210663 (02.11.2023 Gazette 2023/44)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 28.04.2022 JP 2022075431

(71) Applicant: DOWA Electronics Materials Co., Ltd.
Tokyo 101-0021 (JP)

(72) Inventors:
• OSAKO Masaya
  Tokyo 101-0021 (JP)
• NAKANOYA Taro
  Tokyo 101-0021 (JP)
• TAKAHASHI Tetsu
  Tokyo 101-0021 (JP)

(74) Representative: Müller-Boré & Partner
Patentanwälte PartG mbB
Friedenheimer Brücke 21
80639 München (DE)

(54) **SPHERICAL SILVER POWDER, METHOD FOR PRODUCING SPHERICAL SILVER POWDER, APPARATUS FOR PRODUCING SPHERICAL SILVER POWDER, AND CONDUCTIVE PASTE**

(57)    Provided is a spherical silver powder that can bring about excellent fine line printability when used in a conductive paste or the like. The spherical silver powder has a diameter $D_{10}$ at a volume-based cumulative value of 10%, a diameter $D_{50}$ at a volume-based cumulative value of 50%, and a diameter $D_{90}$ at a volume-based cumulative value of 90% according to laser diffraction that satisfy a formula: $(D_{90} - D_{10})/D_{50} < 1$, and has a ratio $(D_{50}/D_{BET})$ of the $D_{50}$ relative to a BET diameter $D_{BET}$ of not less than 0.90 and not more than 1.20.

FIG. 1

**Description**

TECHNICAL FIELD

The present disclosure relates to a spherical silver powder, a method of producing a spherical silver powder, a spherical silver powder production apparatus, and a conductive paste.

BACKGROUND

Conductive pastes that are produced by kneading silver powder together with glass frit in an organic vehicle are used as conductive pastes for internal electrodes of multilayer capacitors, conductive patterns of circuit boards, solar cells, and other electronic components. It is desirable for a silver powder used in such a conductive paste to have a suitably small particle diameter, uniform particle size, and high dispersibility in order to accommodate compactization of electronic components, densification of conductive patterns, fine line formation, and so forth.

As one example of a method of producing such a silver powder for a conductive paste, Patent Literature (PTL) 1 proposes a method of producing a fine particulate silver powder characterized by a silver nitrate aqueous solution and ammonia water being mixed and reacted to obtain a silver ammine complex aqueous solution, this aqueous solution being caused to flow in a certain channel (first channel), a second channel that converges with the first channel partway along the first channel being provided, an organic reductant being caused to flow through this second channel, and contacting and mixing being performed at a confluence point of the first channel and the second channel.

As another example, PTL 2 proposes a method of producing a silver powder by quantitatively and continuously supplying a silver complex-containing silver solution and a reductant solution into a channel and quantitatively and continuously reducing the silver complex in a reaction liquid obtained by mixing the silver solution and the reductant solution inside the channel to obtain a silver powder. A feature of this method of producing a silver powder is that relative to the flow velocity of the silver solution inside of a pipe forming the channel, a ratio of the flow velocity at which the reductant solution is supplied in the same direction as a supply direction of the silver solution from a pipe that is provided on the same axis in the pipe forming the channel is set as 1.5 or more during mixing of the silver solution and the reductant solution.

As another example, PTL 3 proposes a method of producing a spherical silver powder by mixing and reacting a silver nitrate aqueous solution and ammonia water to obtain a silver ammine complex aqueous solution, mixing the silver ammine complex aqueous solution and a reductant aqueous solution in the presence of particles serving as seeds and an imine compound, and thereby causing reduction precipitation of silver particles, wherein the silver ammine complex aqueous solution and the reductant aqueous solution are caused to flow in separate channels that converge at a confluence point, and the silver ammine complex aqueous solution and the reductant aqueous solution are brought into contact and mixed at the confluence point.

As yet another example, PTL 4 proposes a method of producing silver fine particles by adding ammonia and a reductant to a silver ion solution and causing reduction precipitation of silver fine particles, wherein the reductant is added within 20 seconds after ammonia addition so as to cause precipitation of minute silver fine particles. However, in this method, the silver ion solution to which ammonia is added and the reducing solution are mixed outside of a pipe path.

CITATION LIST

Patent Literature

PTL 1: JP2005-48236A
PTL 2: JP2015-45064A
PTL 3: JP2010-70793A
PTL 4: JP2008-255378A

SUMMARY

(Technical Problem)

In a situation in which a conductive paste that contains a silver powder is used to form an internal electrode, a conductive pattern, or the like, it has become desirable that the silver powder enables printing with a thinner line width than is conventionally the case when used in the form of a paste or the like. Silver powders obtained by the production methods of PTL 1 to 4 leave room for improvement with regard to this point.

An object of the present disclosure is to provide a spherical silver powder that can bring about excellent fine line printability when used in a conductive paste or the like and also to provide a production method and a production apparatus for this spherical silver powder.

(Solution to Problem)

The inventors conducted diligent studies to solve the problem set forth above and discovered that in order to obtain excellent fine line printability, it is advantageous to control particle size distribution such that a diameter $D_{10}$ at a volume-based cumulative value of 10%, a diameter $D_{50}$ at a volume-based cumulative value of 50%, and a diameter $D_{90}$ at a volume-based cumulative value of 90% according to laser diffraction satisfy:

$$(D_{90} - D_{10})/D_{50} < 1$$

and also to control dispersibility such that a ratio $(D_{50}/D_{BET})$ of the diameter $D_{50}$ at a volume-based cumulative value of 50% according to laser diffraction relative to a BET diameter $D_{BET}$ is not less than 0.9 and not more than 1.2. In this manner, the inventors completed the present disclosure.

The BET diameter $D_{BET}$ is a particle diameter that is calculated from the BET specific surface area SSA (units: $m^2/g$) measured by the BET single-point method and the true density (units: $g/cm^3$) and is determined by the following formula.

$$D_{BET} = 6/(SSA)/\text{True density}$$

$D_{10}$, $D_{50}$, $D_{90}$, $D_{BET}$, SSA, and true density are taken to be values measured by methods described in the EXAMPLES section. These are measured values prior to classification.

$(D_{90} - D_{10})/D_{50}$ is an indicator of particle size distribution, and when the value thereof is less than 1, this indicates that the spherical silver powder has a sharp particle size distribution and a uniform particle size.

However, a silver powder typically has a state in which the individual particles are not completely separated from one another and in which a plurality of particles are aggregated. Measurement of particle diameter by laser diffraction measures the particle diameter of particles in an aggregated state since the particle diameter is calculated from a diffraction pattern of particles. On the other hand, the BET single-point method measures the specific surface area using the amount of gas that is adsorbed by particles, and the BET diameter that is calculated from this specific surface area indicates the diameter of particles (particle diameter) when the measured particles are assumed to be perfect spheres. When the ratio $(D_{50}/D_{BET})$ is close to 1, this means that the silver powder has a state close to a monodisperse state with little aggregation.

The inventors discovered that in a method of producing a spherical silver powder that includes causing a silver-containing solution to flow in a channel, adding a reductant into the channel at a reductant addition position partway along the channel, and causing reduction precipitation of silver powder inside the channel, it is possible to obtain a spherical silver powder having a uniform particle size and a state close to monodisperse by performing addition of the reductant from a plurality of directions relative to the channel. In this manner, the inventors completed the present disclosure.

Primary features of the present disclosure are as follows.

[1] A spherical silver powder having a diameter $D_{10}$ at a volume-based cumulative value of 10%, a diameter $D_{50}$ at a volume-based cumulative value of 50%, and a diameter $D_{90}$ at a volume-based cumulative value of 90% according to laser diffraction that satisfy a formula:

$$(D_{90} - D_{10})/D_{50} < 1$$

and having a ratio $(D_{50}/D_{BET})$ of the $D_{50}$ relative to a BET diameter $D_{BET}$ of not less than 0.90 and not more than 1.20.
[2] The spherical silver powder according to the foregoing [1], wherein the $D_{50}$ is not less than 0.2 $\mu$m and not more than 3.5 $\mu$m.
[3] The spherical silver powder according to the foregoing [1] or [2], having a BET specific surface area of not less than 0.17 $m^2/g$ and not more than 3.23 $m^2/g$.
[4] The spherical silver powder according to any one of the foregoing [1] to [3], wherein the ratio $(D_{50}/D_{BET})$ is not less than 0.95 and not more than 1.05.
[5] The spherical silver powder according to any one of the foregoing [1] to [4], wherein the $D_{BET}$ is not less than 0.18 $\mu$m and not more than 3.9 $\mu$m.
[6] A method of producing a spherical silver powder comprising causing a silver complex solution to flow in a channel, adding a reductant into the channel at a reductant addition position partway along the channel, and causing reduction precipitation of silver powder inside the channel, wherein addition of the reductant is performed from a plurality of directions relative to the channel.

[7] The method of producing a spherical silver powder according to the foregoing [6], wherein each of the plurality of directions forms an angle of not less than 75° and not more than 105° relative to the channel.

[8] The method of producing a spherical silver powder according to the foregoing [6] or [7], wherein addition of the reductant is performed from all directions of an outer perimeter of the channel.

[9] The method of producing a spherical silver powder according to any one of the foregoing [6] to [8], wherein addition of the reductant is performed with respect to a silver complex solution that contains a surface treatment agent.

[10] The method of producing a spherical silver powder according to any one of the foregoing [6] to [9], wherein a silver-containing solution and a complexing agent are mixed upstream of the reductant addition position in the channel to produce the silver complex solution inside the channel.

[11] A spherical silver powder production apparatus that causes reduction precipitation of silver powder through addition of a reductant to a silver complex solution, comprising a pipe forming a channel for the silver complex solution, wherein a slit having an opening facing in an outward radial direction along an inner perimeter of the pipe is provided in the pipe, and a supply pipe for the reductant is connected to the slit.

[12] The spherical silver powder production apparatus according to the foregoing [11], comprising a plurality of supply pipes for the reductant, wherein at least two of the supply pipes for the reductant are connected to the slit eccentrically to one another.

[13] A conductive paste comprising: the spherical silver powder according to any one of the foregoing [1] to [5]; an organic binder; and a solvent.

[14] The conductive paste according to the foregoing [13] for formation of an electrode of a solar cell.

(Advantageous Effect)

According to the present disclosure, a spherical silver powder that can bring about excellent printability when used in a conductive paste or the like is provided together with a production method and a production apparatus for this spherical silver powder.

BRIEF DESCRIPTION OF THE DRAWINGS

In the accompanying drawings:

FIG. 1 is an external perspective view of one example of a silver powder production apparatus according to the present disclosure;

FIG. 2A is a cross-sectional view perpendicular to a channel for a silver complex solution at a central position of reductant supply pipes of a reductant addition member in a silver powder production apparatus according to the present disclosure;

FIG. 2B is a cross-sectional view at line A-A in FIG. 2A in a direction horizontal with the channel for the silver complex solution;

FIG. 2C is a cross-sectional view at line B-B in FIG. 2A in a direction horizontal with the channel for the silver complex solution;

FIG. 3 is an external perspective view of another example of a silver powder production apparatus according to the present disclosure;

FIG. 4 is an SEM photograph (×5,000) of a silver powder of Example 1;

FIG. 5 is an SEM photograph (×5,000) of a silver powder of Example 2;

FIG. 6 is an SEM photograph (×5,000) of a silver powder of Example 3;

FIG. 7 is an SEM photograph (×5,000) of a silver powder of Example 4;

FIG. 8 is an SEM photograph (×5,000) of a silver powder of Comparative Example 1;

FIG. 9 illustrates the shape of an electrode pattern for EL evaluation of fine line printability;

FIG. 10 is a photograph illustrating EL evaluation results for a conductive paste in which the silver powder of Example 1 was used;

FIG. 11 is a photograph illustrating EL evaluation results for a conductive paste in which the silver powder of Example 2 was used;

FIG. 12 is a photograph illustrating EL evaluation results for a conductive paste in which the silver powder of Example 3 was used;

FIG. 13 is a photograph illustrating EL evaluation results for a conductive paste in which the silver powder of Example 4 was used; and

FIG. 14 is a photograph illustrating EL evaluation results for a conductive paste in which the silver powder of Comparative Example 1 was used.

DETAILED DESCRIPTION

<Spherical silver powder>

A spherical silver powder according to the present disclosure has a diameter $D_{10}$ at a volume-based cumulative value of 10%, a diameter $D_{50}$ at a volume-based cumulative value of 50%, and a diameter $D_{90}$ at a volume-based cumulative value of 90% according to laser diffraction that satisfy a formula:

$$(D_{90} - D_{10})/D_{50} < 1$$

and has a ratio ($D_{50}/D_{BET}$) of the $D_{50}$ relative to a BET diameter $D_{BET}$ of not less than 0.9 and not more than 1.2. The term "spherical" encompasses roughly spherical shapes and means a shape having an average aspect ratio (average ratio of major axis/minor axis) of 1.5 or less.

The value of ($D_{90} - D_{10}$)/$D_{50}$ of the spherical silver powder according to the present disclosure is less than 1, and is preferably 0.96 or less. A smaller value means that the spherical silver powder has a sharper particle size distribution width and a more uniform particle size and is advantageous because excellent printability is obtained. The theoretical lower limit for this value is 0, though an adequate effect is obtained with a value of 0.75 or more.

$D_{50}$ is preferably 0.2 $\mu$m or more, and more preferably 0.5 $\mu$m or more from a viewpoint of ease of paste handling when the spherical silver powder is used as a conductive paste. Moreover, $D_{50}$ is preferably 3.5 $\mu$m or less, and more preferably 3.0 $\mu$m or less from a viewpoint of being advantageous in terms of low-temperature sintering ability of a wiring pattern formed using a conductive paste or the like, and also from a viewpoint of ease of accommodating densification, etc.

The ratio ($D_{50}/D_{BET}$) of the spherical silver powder according to the present disclosure is not less than 0.90 and not more than 1.20, and is preferably not less than 0.95 and not more than 1.05, and more preferably 1.04 or less from a viewpoint of obtaining even better dispersibility.

The BET specific surface area (SSA) is the specific surface area measured according to the BET single-point method and is preferably 0.17 $m^2$/g or more, and more preferably 0.20 $m^2$/g or more from a viewpoint of being advantageous in terms of low-temperature sintering ability of a wiring pattern formed using a conductive paste or the like, and also from a viewpoint of ease of accommodating densification, etc. Moreover, the BET specific surface area (SSA) is preferably 3.23 $m^2$/g or less, and more preferably 2.40 $m^2$/g or less from a viewpoint of ease of paste handling when the spherical silver powder is used as a conductive paste.

The true density is preferably more than 9.0 $g/cm^3$, and more preferably 9.4 $g/cm^3$ or more from a viewpoint of ease of accommodating densification of a wiring pattern, etc., and is preferably less than 10.45 $g/cm^3$, more preferably 10.0 $g/cm^3$ or less, and even more preferably 9.9 $g/cm^3$ or less from a viewpoint of low-temperature sintering ability.

$D_{BET}$ is the BET diameter ($\mu$m) that is calculated by the following formula using the specific surface area ($m^2$/g) measured by the BET single-point method and the true density ($g/cm^3$).

$$\text{BET diameter} = 6/\text{Specific surface area}/\text{True density}$$

$D_{BET}$ is preferably 0.18 $\mu$m or more, and more preferably 0.45 $\mu$m or more, and is preferably 3.9 $\mu$m or less, and more preferably 3.2 $\mu$m or less.

The tap density of the spherical silver powder according to the present disclosure is preferably 2.5 $g/cm^3$ or more, and more preferably 4.5 $g/cm^3$ or more from a viewpoint of ease of accommodating high-accuracy patterning, etc. On the other hand, the upper limit for the tap density is 7.8 $g/cm^3$ when the true density of silver and densest packing of a uniform spherical powder are taken into account.

<Method of producing spherical silver powder>

A method of producing a spherical silver powder according to the present disclosure includes causing a silver complex solution to flow in a channel, adding a reductant into the channel at a reductant addition position partway along the channel, and causing reduction precipitation of silver powder inside the channel, wherein addition of the reductant is performed from a plurality of directions relative to the channel. By continuously supplying a silver complex solution and a reductant and performing quantitative mixing thereof in the production method according to the present disclosure, it is possible to maintain the rate of reduction precipitation of silver powder as a fixed rate and to quantitatively and continuously obtain a spherical silver powder.

In the method of producing a spherical silver powder according to the present disclosure, the reductant and the silver complex solution are mixed as a result of the reductant being added into the channel from a plurality of directions relative to the channel at the reductant addition position. The addition of the reductant to the silver complex solution from a plurality of directions at a position where the reductant is added into the channel (reductant addition position) improves mixing efficiency of the reductant and the silver complex solution and reduces the amount of unreacted silver ions, thereby inhibiting secondary nucleation by unreacted silver ions. This is presumed to enable control of $(D_{90} - D_{10})/D_{50}$ and the ratio $(D_{50}/D_{BET})$ to within specific ranges. Since a silver powder having a sharp particle size distribution width can be obtained even without classification treatment, it is possible to simplify the production process.

An effect such as described above cannot be obtained in a situation in which the reductant is added from one direction relative to the channel because this necessitates time for the reductant to reach an opposite side relative to the addition point thereof and results in variation of concentration of the reductant at the reductant addition position. For the same reason, such an effect cannot be obtained in a situation in which the silver complex solution and the reductant are brought into contact and mixed at a confluence using a Y-shaped pipe or a T-shaped pipe.

Moreover, in a situation in which the reductant is added at a central position in the channel from a coaxial double pipe, this necessitates time for mixing of the silver complex solution and the reductant because the reductant is added in parallel to flow of the silver complex solution, and there is a higher tendency for particle growth to become non-uniform because, in the case of a coaxial double pipe, the flow velocity at the center of the pipe is relatively fast, whereas the flow velocity in proximity to a wall surface is relatively slow.

Addition of the reductant is preferably performed from two or more directions relative to the channel, more preferably performed from four or more directions relative to the channel, and particularly preferably performed from all directions of an outer perimeter of the channel. Addition of the reductant from a plurality of directions relative to the channel can be performed through the number and shape of subsequently described openings.

Each of the plurality of directions preferably forms an angle of not less than 75° and not more than 105° relative to the channel. Addition of the reductant into the channel roughly perpendicularly is advantageous in terms of quickly mixing the silver complex solution and the reductant. The angle relative to the channel is more preferably not less than 80° and not more than 100°. The phrase "relative to the channel" used above can also be rephrased as "relative to an axial direction of a pipe in which the silver complex solution flows".

The silver complex solution in the production method according to the present disclosure is not specifically limited so long as it is a solution that is reduced by the reductant to cause precipitation of silver, but is preferably a silver ammine complex solution. The silver ammine complex solution can be produced by a method in which silver chloride is dissolved in ammonia water or a method in which a silver nitrate aqueous solution and ammonia water are mixed, for example.

A silver complex solution that has been separately produced may be caused to flow in the channel or a silver-containing solution (for example, a silver nitrate aqueous solution) and a complexing agent (for example, ammonia water) may be caused to react further upstream than the reductant addition position in the channel to form a silver complex solution inside the channel. In a case in which the silver complex solution is produced outside of the channel, the stability of the complex at the time of reduction can vary depending on the time taken until the silver complex solution is supplied into the channel. In other words, there is lack of stability because sufficient complexation may not occur in a situation in which the time from mixing of the silver-containing solution and the complexing agent until addition of the reductant is too short and the formation of by-products in the silver complex solution may occur in a situation in which the time from mixing of the silver-containing solution and the complexing agent until addition of the reductant is too long. On the other hand, in a situation in which the silver complex solution is produced inside the channel, the state of the complex at the time of reduction is fixed because the reductant is added after a fixed time has elapsed, and this is advantageous in terms of controlling the shape of a spherical silver powder. For example, the silver complex solution can be produced by causing a silver-containing solution (for example, a silver nitrate aqueous solution) to flow inside the channel, supplying a complexing agent (for example, ammonia water) through a coaxial double pipe or the like, and causing mixing and reaction of the silver-containing solution and the complexing agent.

The reductant in the production method according to the present disclosure is not specifically limited and can be hydrazine, ascorbic acid, hydroquinone, formalin (formaldehyde aqueous solution), or the like. Formalin, hydrazine, or the like is preferable from a viewpoint of ease of controlling the reduction reaction.

The additive amount of the reductant is preferably 1.1 equivalents or more, and more preferably 1.2 equivalents or more relative to silver from a viewpoint of ensuring sufficient reaction efficiency and avoiding the retention of unreacted silver complex, and is preferably 25.0 equivalents or less, and more preferably 20.0 equivalents or less relative to silver from a financial viewpoint.

The silver concentration of the silver complex solution is preferably set such that the silver concentration after mixing with the reductant is 0.01 mol/L or more, and more preferably 0.05 mol/L or more from a viewpoint of ensuring sufficient reaction efficiency, and is preferably set such that the silver concentration after mixing with the reductant is 0.5 mol/L or less, and more preferably 0.3 mol/L or less from a viewpoint of strictly adjusting the particle diameter and particle size distribution of the silver powder that undergoes reduction precipitation.

In the production method according to the present disclosure, the flow velocity of the silver complex solution directly before addition of the reductant into the channel is preferably 8 L/min or more, and more preferably 12 L/min or more from a viewpoint of productivity, and is preferably 275 L/min or less, and more preferably 230 L/min or less from a viewpoint of inhibiting aggregation and forming monodisperse particles.

The flow velocity of the reductant when the reductant is added into the channel is 0.5 times or more the flow velocity of the silver complex solution directly before reductant addition, and is preferably 2.5 times or less, and more preferably 1.3 times or less the flow velocity of the silver complex solution directly before reductant addition from a viewpoint of inhibiting increased liquid flow to a piping wall surface and reduction of mixing efficiency. This flow velocity is even more preferably not less than 0.9 times and not more than 1.1 times the flow velocity of the silver complex solution directly before reductant addition.

In the production method according to the present disclosure, it is advantageous in terms of inhibiting aggregation of silver powder that has undergone reduction precipitation that the reaction of the silver complex solution and the reductant is performed in the presence of a surface treatment agent. A configuration in which the surface treatment agent is compounded with the silver complex solution in advance or a configuration in which the surface treatment agent is mixed with the reductant in advance may be adopted. Alternatively, in a case in which the silver complex solution is obtained inside of the channel using a silver-containing solution and a complexing agent, the surface treatment agent may be compounded in advance with the silver-containing solution, for example. The surface treatment agent may be added into the channel upstream or downstream of the reductant addition position, but is preferably added upstream of the reductant addition position from a viewpoint of inhibiting aggregation and forming monodisperse particles.

The surface treatment agent may be a fatty acid, a fatty acid salt, a surfactant, an organometallic, a chelating agent, a protective colloid, or the like. The surface treatment agent can be used in an amount such as to be not less than 0.03 mass% and not more than 1.0 mass% relative to silver in the silver-containing solution.

(1) Fatty acid

The fatty acid may be propionic acid, caprylic acid, lauric acid, myristic acid, palmitic acid, stearic acid, behenic acid, acrylic acid, oleic acid, linoleic acid, arachidonic acid, ricinoleic acid, or the like. The surface treatment agent may be used in the form of an emulsion, a solution, or the like.

(2) Fatty acid salt

The fatty acid salt may be a metal salt of any of the fatty acids described above in (1), where the metal may be lithium, sodium, potassium, barium, magnesium, calcium, aluminum, iron, cobalt, manganese, lead, zinc, tin, strontium, zirconium, silver, copper, or the like.

(3) Surfactant

The surfactant may be an anionic surfactant such as an alkylbenzenesulfonic acid salt or a polyoxyethylene alkyl ether phosphoric acid salt, a cationic surfactant such as an aliphatic quaternary ammonium salt, an amphoteric surfactant such as an imidazolinium betaine, or a non-ionic surfactant such as a polyoxyethylene alkyl ether or a polyoxyethylene fatty acid ester.

(4) Organometallic

The organometallic may be acetylacetone tributoxyzirconium, magnesium citrate, diethylzinc, dibutyltin oxide, dimethylzinc, tetra-n-butoxyzirconium, triethylindium, triethylgallium, trimethylindium, trimethylgallium, monobutyltin oxide, tetraisocyanatosilane, tetramethylsilane, tetramethoxysilane, monomethyltriisocyanatosilane, a silane coupling agent, a titanate-based coupling agent, an aluminum-based coupling agent, or the like.

(5) Chelating agent

The chelating agent may be imidazole, oxazole, thiazole, selenazole, pyrazole, isoxazole, isothiazole, 1H-1,2,3-triazole, 2H-1,2,3-triazole, 1H-1,2,4-triazole, 4H-1,2,4-triazole, 1,2,3-oxadiazole, 1,2,4-oxadiazole, 1,2,5-oxadiazole, 1,3,4-oxadiazole, 1,2,3-thiadiazole, 1,2,4-thiadiazole, 1,2,5-thiadiazole, 1,3,4-thiadiazole, 1H-1,2,3,4-tetrazole, 1,2,3,4-oxatriazole, 1,2,3,4-thiatriazole, 2H-1,2,3,4-tetrazole, 1,2,3,5-oxatriazole, 1,2,3,5-thiatriazole, indazole, benzimidazole, benzotriazole, or the like; a salt of any of these chelating agents; a dicarboxylic acid such as succinic acid, malonic acid, glutaric acid, or adipic acid or another such polycarboxylic acid; or the like.

(6) Protective colloid

The protective colloid may be a peptide, gelatin, albumin, gum Arabic, protalbic acid, lysalbic acid, glue, or the like.

The surface treatment agent is preferably the (1) fatty acid from a viewpoint of ease of modification of the surfaces of silver particles. In particular, stearic acid is preferable. The (1) fatty acid is preferably in the form of an emulsion. For example, a stearic acid emulsion or the like may be used.

In the production method according to the present disclosure, the temperature of liquid flowing in the channel is preferably 5°C or higher, and more preferably 15°C or higher from a viewpoint of the reduction reaction, and is preferably 60°C or lower, and more preferably 50°C or lower from an operational viewpoint.

In the production method according to the present disclosure, a mixer may be used to impart spiral rotation in an axial direction of the channel so as to perform liquid mixing.

A spherical silver powder can be obtained in the production method according to the present disclosure by discharging a liquid containing silver powder that has undergone reduction precipitation (hereinafter, also referred to as a "silver powder-containing liquid") to outside of the channel and collecting the liquid. The time from the reductant addition position to an outlet for the silver powder-containing liquid is preferably 1 second or more, and more preferably 2 seconds or more from a viewpoint that completion of the reduction reaction can be expected, and is preferably 10 seconds or less, and more preferably 5 seconds or less from a viewpoint of inhibiting settling in piping.

The silver powder-containing liquid that has been discharged to outside of the channel is subjected to filtration and water washing to obtain a lumpy cake that contains the silver powder and water and that has almost no fluidity.

This cake is dried by a dryer such as a forced circulation air dryer, a vacuum dryer, or a pneumatic conveying dryer to yield the spherical silver powder according to the present disclosure. Substitution of water in the cake with a lower alcohol or the like enables quicker drying.

The cake can be subjected to dry disintegration treatment, surface smoothing treatment, or the like. The surface smoothing treatment can be performed by causing particles to mechanically collide with one another using a high-speed stirrer.

Classification treatment may subsequently be performed in order to remove aggregates of the silver powder that are larger than a specific particle diameter.

Moreover, drying, grinding, and classification may be performed with respect to the cake using an integrated apparatus that is capable of performing drying, disintegration, and classification (for example, a DRYMEISTER or MICRON DRYER produced by Hosokawa Micron Corporation).

<Silver powder production apparatus>

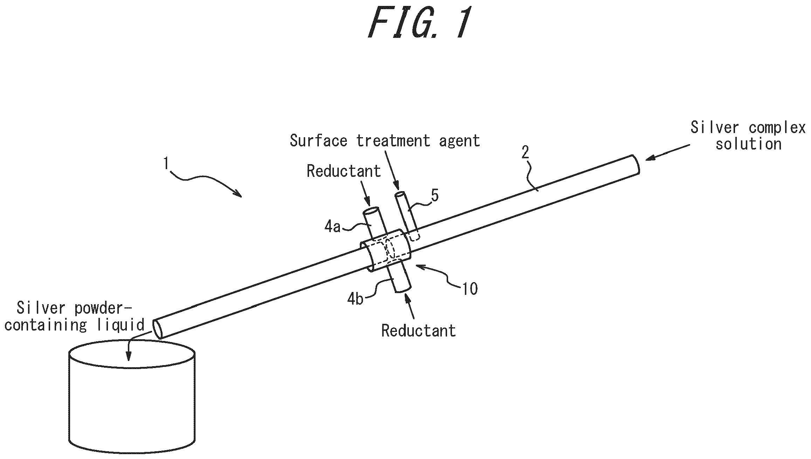

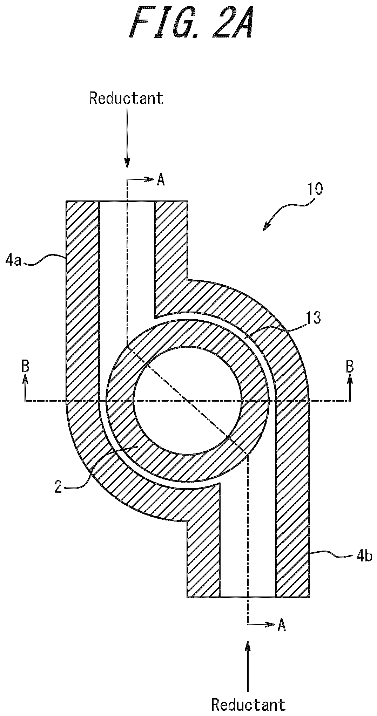

No specific limitations are placed on an apparatus that is used in the production method according to the present disclosure so long as it can perform addition of a reductant from a plurality of directions relative to a channel. For example, it is advantageous to use a silver powder production apparatus that includes a pipe forming a channel for a silver complex solution, that has openings provided at two or more locations in the pipe or an opening provided along the entire perimeter of the pipe, and that has a supply pipe for a reductant connected to the opening(s). One example of such a silver powder production apparatus is described using FIG. 1 and FIGS. 2A to 2C.

FIG. 1 is an external perspective view of one example of a silver powder production apparatus according to the present disclosure that includes a pipe 2 along which a silver complex solution flows, reductant supply pipes 4a and 4b that supply a reductant, and a reductant addition member 10.

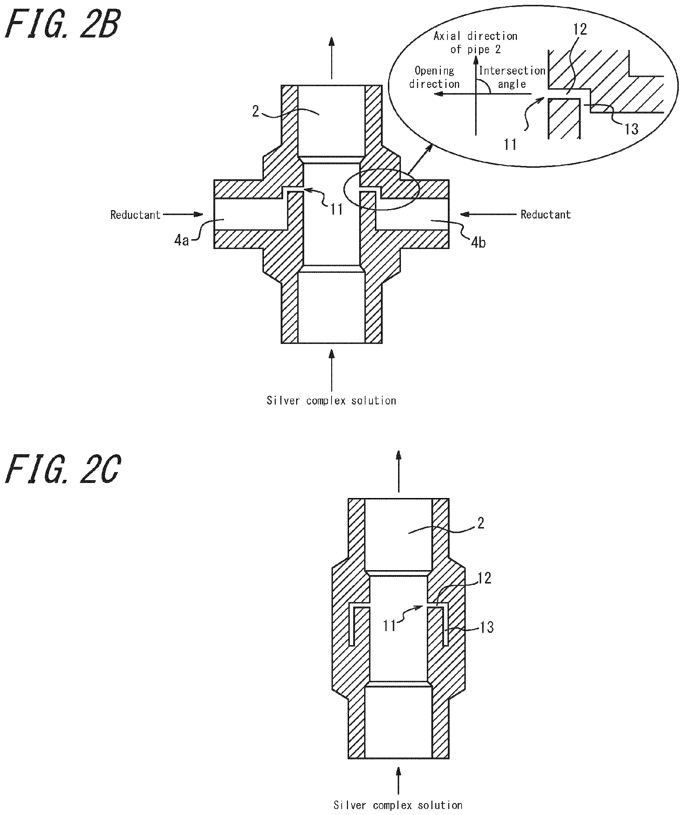

FIG. 2A is a cross-sectional view perpendicular to a channel for the silver complex solution at a central position of the reductant supply pipes 4a and 4b of the reductant addition member 10 in FIG. 1. FIG. 2B is a cross-sectional view at line A-A in FIG. 2A that is a cross-sectional view in a direction horizontal with the channel for the silver complex solution. FIG. 2C is a cross-sectional view at line B-B in FIG. 2A that is a cross-sectional view in a direction horizontal with the channel for the silver complex solution.

In FIG. 2A, a gap 13 is present along an outer perimeter of the pipe 2 that serves as a channel for the silver complex solution, and the gap 13 is connected with the insides of the reductant supply pipes 4a and 4b. As illustrated in FIG. 2C, which is a cross-sectional view at line B-B in FIG. 2A, a side of the gap 13 that is downstream in the channel for the silver complex solution is connected to a slit section 12 having an opening 11 facing in an outward radial direction along an inner perimeter of the pipe 2. Moreover, as illustrated in FIG. 2B, which is a cross-sectional view at line A-A in FIG. 2A, when the reductant flows into the gap 13 through the inside of the reductant supply pipe 4a and the inside of the reductant supply pipe 4b, the reductant reaches the slit section 12 via the inside of the gap 13, and the reductant enters the pipe 2 from the opening 11 of the slit section 12 roughly perpendicularly (for example, at not less than 75° and not more than 105°) from the entire perimeter of the pipe 2 and is added to the silver complex solution. The angle at which the reductant enters relative to the channel for the silver complex solution is an angle of intersection of an axial direction of the pipe 2 and an opening

EP 4 516 431 A1

direction of the opening 11 where the reductant enters the pipe 2. The opening direction can be regarded as a direction along a wall surface in proximity to the opening of the slit section 12 as illustrated in FIG. 2B.

The flow velocity of the reductant when the reductant is added into the channel for the silver complex solution can be controlled through the flow rate of the reductant flowing in the reductant supply pipes 4a and 4b and the size of the total area of the opening 11. By controlling the flow velocity of the reductant to within any of the previously described ranges, it is possible to quickly perform a reaction of the silver complex and the reductant and to thereby obtain a silver powder having a sharp particle size distribution width.

The width of the opening 11 included in the slit section 12 in FIG. 2B and FIG. 2C is referred to as the slit width. The slit width is preferably set as narrower than the reductant supply pipe diameter in order to reduce the size of the total area of the opening 11. Shapes of the gap 13 and the slit section 12 that enable addition of the reductant from a plurality of directions relative to the channel and that enable the formation of a narrower slit width than the reductant supply pipe diameter are not limited to the structure in FIGS. 2A to 2C, and various modifications can be made. Moreover, the opening 11 of the slit section 12 can be modified in a manner such that it is provided as a plurality of through holes rather than along the entire perimeter of the pipe 2, for example.

The number of reductant supply pipes by which the reductant flows into the reductant addition member 10 may be one or more, and is preferably two or more. In a case in which there are two or more reductant supply pipes, channels for the reductant that join to the opening 11 from the reductant supply pipes can be provided opposite to one another or eccentrically to one another. In FIGS. 2A to 2C, the reductant supply pipes 4a and 4b are connected eccentrically to one another relative to the center of the pipe 2, and channels of the reductant supply pipes 4a and 4b are connected to the slit section 12 including the opening 11. When connecting a plurality of reductant supply pipes, setting at least two of the reductant supply pipes eccentrically to one another makes it possible to cause the reductant to flow into the opening 11 included in the slit section 12 while causing rotation of the reductant in one direction at the outer perimeter of the channel (pipe 2) for the silver complex solution.

In a situation in which the reductant rotates at the outer perimeter of the channel for the silver complex solution, the flow rate of the reductant toward the opening 11 may be adjusted by altering the cross-sectional area of a channel (gap 13 or slit section 12) for the reductant.

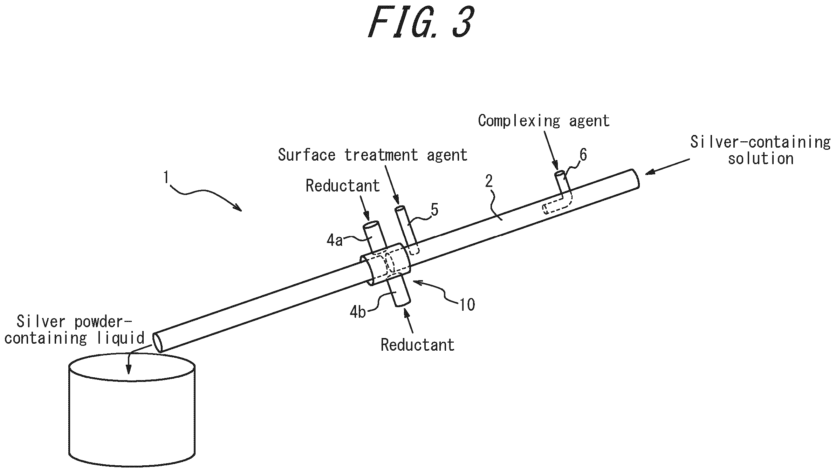

Although a silver complex solution is supplied into the pipe 2 in FIG. 1, it may alternatively be the case that, as illustrated in FIG. 3, a coaxial double pipe having a coaxial complexing agent supply pipe 6 for supplying a complexing agent disposed at an inner side of the pipe 2 is provided at an upstream side of the reductant addition member 10 in the pipe 2, a silver-containing solution is supplied from the pipe 2, which is an outer pipe path, a complexing agent is supplied from the complexing agent supply pipe 6, which is an inner pipe path, and mixing and reaction of the silver-containing solution and the complexing agent are performed to obtain a silver complex solution.

Moreover, in FIGS. 1 and 3, an optional surface treatment agent supply pipe 5 for a surface treatment agent is provided at an upstream side of the reductant addition member 10 in the pipe 2. It is preferable for the surface treatment agent supply pipe 5 to be provided at an upstream side of the reductant addition member 10 rather than at a downstream side of the reductant addition member 10. By providing the surface treatment agent supply pipe 5 at an upstream side, it is possible to perform addition of the reductant with respect to a silver complex solution that contains a surface treatment agent. This makes it possible to further sharpen the particle size distribution width of the obtained silver powder.

<Conductive paste>

The spherical silver powder according to the present disclosure can provide a conductive paste having excellent printability and low-temperature sintering ability and is suitable for a conductive paste that is used for internal electrodes of multilayer capacitors, conductive patterns of circuit boards, electrodes and circuits of solar cells and other electronic components, and so forth.

A conductive paste according to the present disclosure can contain the spherical silver powder according to the present disclosure, an organic binder, and a solvent.

The organic binder may be silicone resin, epoxy resin, acrylic resin, polyester resin, polyimide resin, polyurethane resin, phenoxy resin, cellulosic resin (ethyl cellulose, hydroxypropyl cellulose, etc.), or the like, for example, without any specific limitations. One of these organic binders may be used individually, or two or more of these organic binders may be used in combination in a freely selected ratio.

The solvent may be an alcohol solvent such as terpineol, butyl carbitol, texanol, ethylene glycol, diethylene glycol, or glycerin; an ester solvent such as butyl carbitol acetate or ethyl acetate; a hydrocarbon solvent such as toluene, xylene, or cyclohexane; or the like, for example, without any specific limitations. One of these solvents may be used individually, or two or more of these solvents may be used in combination in a freely selected ratio.

The content of the spherical silver powder according to the present disclosure in the conductive paste can be set as 80 mass% or more, and is preferably 85 mass% or more. Moreover, the content of the spherical silver powder according to the present disclosure in the conductive paste can be set as 95 mass% or less, and is preferably 90 mass% or less.

The content of the organic binder in the conductive paste can be set as 0.1 mass% or more, and is preferably 0.2 mass% or more. Moreover, the content of the organic binder in the conductive paste can be set as 0.4 mass% or less, and is preferably 0.3 mass% or less.

The content of the solvent in the conductive paste can be set as 6 mass% or more, and is preferably 7 mass% or more. Moreover, the content of the solvent in the conductive paste can be set as less than 20 mass%, and is preferably 15 mass% or less.

The conductive paste can contain glass frit, a dispersant, a surfactant, a viscosity modifier, a slip agent, and so forth as optional components. In a case in which the conductive paste is used in production of an electrode of a solar cell, it is preferable that the conductive paste contains glass frit. The glass frit may be glass frit based on Pb-Te-Bi, Pb-Si-B, or the like.

The production method of the conductive paste is not specifically limited and may be a method in which the spherical silver powder according to the present disclosure, the organic binder, the solvent, and, in some cases, optional components are mixed. The method of mixing is not specifically limited and can be performed using a planetary stirrer, an ultrasonic disperser, a disper, a three-roll mill, a ball mill, a bead mill, a twin-screw kneader, or the like.

The conductive paste according to the present disclosure can be applied onto a substrate to form a coating film by dipping, printing such as screen printing, offset printing, or photolithography, or the like, for example. The coating film may be provided with a specific patterned shape through photolithography using a resist, for example.

The coating film can be fired to form a conductive film. The firing may be performed in an air atmosphere or may be performed in a non-oxidizing atmosphere such as nitrogen.

The firing temperature of the coating film can be set as not lower than 600°C and not higher than 800°C, and is preferably not lower than 690°C and not higher than 760°C. The firing time can be set as not less than 20 seconds and not more than 1 hour. The firing time is preferably 40 seconds or more, and is preferably 20 minutes or less, and more preferably 2 minutes or less.

The conductive paste according to the present disclosure can suitably be used for formation of internal electrodes of multilayer capacitors, conductive patterns of circuit boards, and electrodes and circuits of solar cells and other electronic components.

EXAMPLES

The following describes examples according to the present disclosure. However, the present disclosure is not limited by these examples.

[Evaluation of silver powder]

Silver powders of examples and a comparative example were evaluated as follows.

<True density>

True density was measured by a fixed-volume expansion method ("Gas pycnometer method" in Japanese Pharmacopoeia) using a dry-type automatic density meter (produced by Micromeritics Instrument Corporation; instrument name: AccuPyc II 1340).

<BET specific surface area>

BET specific surface area was measured using a fully automated specific surface area measurement instrument (produced by Mountech Co., Ltd.; instrument name: Macsorb HM-model 1210). A silver powder was loaded into the instrument, deaeration was performed through ventilation with He-$N_2$ mixed gas (30% nitrogen) at 60°C for 10 minutes, and measurement was subsequently performed by the BET single-point method.

<$D_{10}$, $D_{50}$, and $D_{90}$>

$D_{10}$, $D_{50}$, and $D_{90}$ were determined by laser diffraction wet sample measurement using a Microtrac particle size distribution measurement instrument (produced by MicrotracBEL Corp.; instrument name: MT-3300EXII). In this measurement, 0.1 g of a sample (silver powder) was added to and dispersed in 40 mL of isopropyl alcohol (IPA). Dispersing was performed using an ultrasonic homogenizer (produced by NIHONSEIKI KAISHA LTD.; instrument name: US-150T; 19.5 kHz; tip diameter: 18 mm). The dispersing time was set as 2 minutes. The dispersed sample was supplied into the above-described instrument, and a particle size distribution was determined by analysis software accompanying the instrument.

<Tap density>

The tap density (TAP) was taken to be a value determined using a tap density measurement instrument (Bulk specific gravity measurement instrument SS-DA-2 produced by Shibayama Scientific Co., Ltd.). Measurement of tap density was performed as follows. After weighing out 30 g of a silver powder and loading this silver powder into a 20 mL test tube, the test tube was subject to tapping 1,000 times with a drop of 20 mm. The sample volume (cm$^3$) after tapping was determined. The tap density (g/cm$^3$) was determined by the following formula.

$$\text{Tap density (g/cm}^3) = 30 \text{ (g)/Sample volume after tapping (cm}^3)$$

[Production of silver powder]

Silver powders of examples and a comparative example were produced as follows.

<Example 1>

A silver powder was produced using the apparatus illustrated in FIG. 3 and FIGS. 2A to 2C.

A 0.13 mol/L silver nitrate aqueous solution was introduced into a pipe 2 (internal diameter: 20 mm) at a flow rate of 25.1 L/min with a liquid temperature of 22°C, and a 9.2 mass% ammonia aqueous solution was introduced at a flow rate of 2.69 L/min from a supply pipe 6 (internal diameter: 6 mm) that was a coaxial double pipe so as to produce a silver ammine complex inside the pipe 2.

A surface treatment agent (0.18 mass% Selosol 920 (produced by Chukyo Yushi Co., Ltd.; containing 15.5 mass% of stearic acid)) was introduced at a flow rate of 2.19 L/min from a supply pipe 5 (internal diameter: 6 mm) upstream of a reductant addition member 10. The amount of the silver nitrate aqueous solution is an amount that results in a silver concentration of 0.1 mol/L in the total amount of liquid after addition of the complexing agent, formalin, and the surface treatment agent. The additive amount (target value) of stearic acid is an amount such that stearic acid is 0.18 mass% relative to silver.

Formalin (19.8 mass% formaldehyde aqueous solution) was introduced at a flow rate of 2.55 L/min from the entire perimeter of a slit section (slit width: 0.44 mm; pipe internal diameter: 20.6 mm) of the reductant addition member 10 so as to cause precipitation of silver powder. The flow velocity of the reductant entering from the slit section having a slit width of 0.44 mm is 1.49 m/s, the flow velocity of a silver ammine complex directly before reductant addition in the internal diameter of 20.6 mm of the pipe 2 at the position where the reductant enters is 1.50 m/s, and a ratio of the flow velocity of the complex relative to the flow velocity of the reductant (complex flow velocity/reductant flow velocity) is 1.01.

The operating time of the silver powder production apparatus (time between initiation and suspension of reductant introduction with respect to the silver ammine complex after flow of the silver ammine complex to which the surface treatment agent has been introduced stabilized) was set as 37 seconds.

In the above, the time from an inlet of the channel for the silver nitrate aqueous solution to the ammonia aqueous solution addition position was 1 second, the time from the ammonia aqueous solution addition position to the formalin addition position was 2.12 seconds (2.1 m), the time from the surface treatment agent addition position to the formalin addition position was 0.123 seconds, and the temperature of the silver ammine complex solution directly before the formalin addition position was 27.8°C.

A silver powder-containing slurry was discharged from the pipe 2. The time from the formalin addition position to discharge was approximately 2 seconds. After the reduction reaction had stabilized, the silver powder-containing slurry was collected, was subjected to solid-liquid separation to obtain solid material, and this solid material was washed with pure water so as to remove impurities in the solid material. The end point of this washing can be judged from the electrical conductivity of water after washing. The washing was performed until this electrical conductivity was 0.5 mS/m or less to yield 217 g of a silver powder.

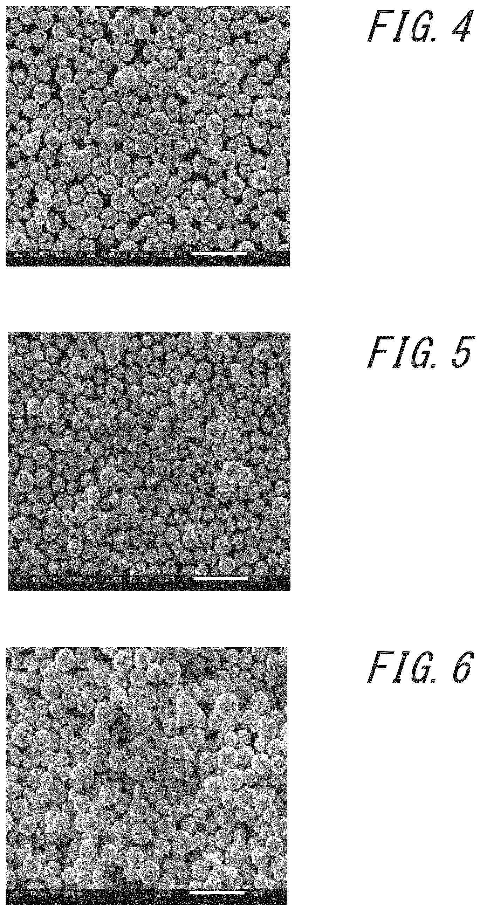

Other production conditions and evaluation results are shown in Tables 1 and 2. An SEM photograph (×5,000) is presented in FIG. 4.

<Examples 2 to 4>

A silver powder was produced in the same way as in Example 1 with the exception that conditions were changed as shown in Table 1. A mixer was used in Examples 3 and 4. The operating times of the silver powder production apparatus in Example 2, Example 3, and Example 4 were respectively 33 seconds, 43 seconds, and 870 seconds. The obtained silver powders were respectively 193 g, 126 g, and 5,091 g.

Evaluation results for Examples 2 to 4 are shown in Table 2. Moreover, SEM photographs (×5,000) of the silver powders of Examples 2 to 4 are presented in FIGS. 5 to 7.

<Comparative Example 1>

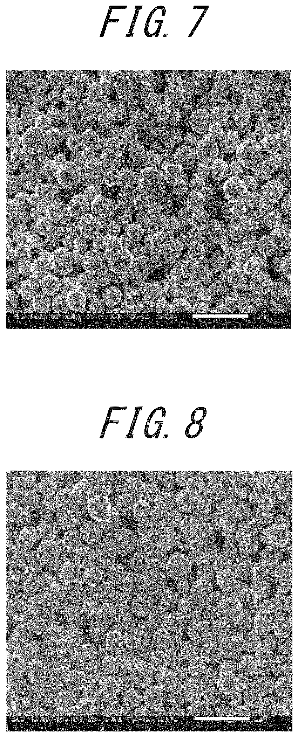

A coaxial double pipe having a coaxial supply pipe (internal diameter: 6 mm) for supplying formalin disposed at an inner side of the pipe 2 was installed instead of the reductant addition member 10 of the silver powder production apparatus in FIG. 3, and formalin (19.8 mass% formaldehyde aqueous solution) was introduced at a flow rate of 2.55 L/min so as to cause precipitation of silver powder. The operating time of the silver powder production apparatus was set as 47 seconds. With the exception of the above, production was performed in the same way as in Example 1 or as indicated in Table 1. The obtained silver powder was 275 g. The evaluation results are shown in Table 2. An SEM photograph (×5,000) of the silver powder of Comparative Example 1 is presented in FIG. 8.

[Table 1]

| | Reductant addition method | Complex flow velocity [m/s] | Reductant flow velocity [m/s] | Complex flow velocity/ Reductant flow velocity | Mixer | Silver concentration* [mol/L] | $NH_3$ equivalents | HCHO equivalents | Treatment agent additive amount [mass%] ** | Complex temperature [°C] |
|---|---|---|---|---|---|---|---|---|---|---|
| Comparative Example 1 | Coaxial double pipe | 1.63 | 1.50 | 1.09 | No | 0.1 | 2.35 | 9.20 | 0.18 | 21.0 |
| Example 1 | Slit | 1.50 | 1.49 | 1.01 | No | 0.1 | 2.14 | 10.9 | 0.18 | 27.8 |
| Example 2 | Slit | 1.75 | 1.74 | 1.01 | No | 0.1 | 2.57 | 11.4 | 0.18 | 30.4 |
| Example 3 | Slit | 2.00 | 1.99 | 1.01 | Yes | 0.05 | 2.35 | 11.4 | 0.18 | 29.5 |
| Example 4 | Slit | 1.50 | 1.49 | 1.01 | Yes | 0.1 | 2.35 | 11.4 | 0.18 | 31.1 |

* Silver concentration in total amount of liquid after addition of complexing agent, formalin, and surface treatment agent
** Additive amount (target value) of stearic acid relative to silver

[Table 2]

| | True density [g/cm³] | BET specific surface area [m²/g] | $D_{10}$ [μm] | $D_{50}$ [μm] | $D_{90}$ [μm] | $(D_{90} - D_{10})/D_{30}$ | $D_{50}/D_{BET}$ | Tap density [g/cm³] |
|---|---|---|---|---|---|---|---|---|
| Comparative Example 1 | 9.37 | 0.28 | 1.47 | 2.45 | 5.53 | 1.66 | 1.06 | 5.8 |
| Example 1 | 9.76 | 0.34 | 1.20 | 1.77 | 2.75 | 0.88 | 0.99 | 5.8 |
| Example 2 | 9.72 | 0.38 | 1.07 | 1.61 | 2.60 | 0.95 | 1.00 | 5.9 |
| Example 3 | 9.78 | 0.35 | 1.21 | 1.81 | 2.91 | 0.94 | 1.04 | 5.8 |
| Example 4 | 9.71 | 0.31 | 1.27 | 1.86 | 3.03 | 0.95 | 0.95 | 6.0 |

[Production of conductive paste]

The silver powders of the examples and comparative example were each used to produce a conductive paste as follows.

The silver powder of each example or comparative example was used to obtain a conductive paste by performing the following treatment with a composition ratio shown below in Table 3. The substances were stirred and mixed at 1,400 rpm for 30 seconds using a propeller-less planetary stirring and defoaming device (AR310 produced by Thinky Corporation) and were subsequently kneaded by a three-roll mill (80S produced by Exakt Technologies Inc.) through passing with a roll gap of from 100 μm to 20 μm.

[Table 3]

| | Examples 1, 2, 4 Comparative Example 1 [mass%] | Example 3 [mass%] |
|---|---|---|
| Ethyl cellulose | 0.10 | 0.10 |
| Hydroxypropyl cellulose | 0.10 | 0.10 |
| Wax* | 0.07 | 0.07 |
| Triethylene glycol butyl methyl ether | 1.83 | 1.96 |
| Terpineol | 1.20 | 1.33 |
| Texanol | 1.28 | 1.28 |
| Butyl carbitol acetate | 1.18 | 1.18 |
| Tributyl citrate | 1.34 | 1.47 |
| Dimethyl polysiloxane 100 cs** | 0.40 | 0.40 |
| Triethanolamine | 0.26 | 0.26 |
| Castor oil | 0.07 | 0.07 |
| Oleic acid | 0.69 | 0.82 |
| Pb-Te-Bi-based glass frit | 1.99 | 2.12 |
| Silver powder of example/comparative example | 89.48 | 88.84 |
| Total | 100.00 | 100.00 |
| * NAMLON206T produced by Kusumoto Chemicals, Ltd. ** KF96-100 produced by Shin-Etsu Chemical Co., Ltd. | | |

[Evaluation of fine line printability]

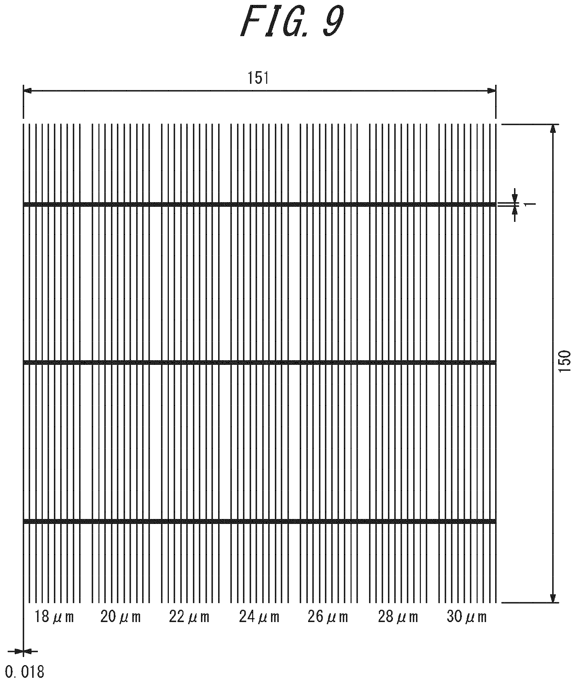

Fine line evaluation (EL) was performed by forming and evaluating a conductive pattern. Formation of the conductive pattern was performed as follows. First, an aluminum paste (28D22G-2 produced by Rutech) was used to form a 154 mm solid pattern on a rear surface of a silicon substrate (100 Ω/sq.) for a solar cell using a screen printer (MT-320TV produced by Micro-tec Co., Ltd.). Next, the above-described conductive paste produced using the silver powder of each example or comparative example was filtered at 500-mesh and was subsequently used to print (apply) electrodes (finger electrodes) with line widths of 14 μm to 26 μm and electrodes (busbar electrodes) with a width of 1 mm at a squeegee speed of 350 mm/sec in a pattern illustrated in FIG. 9 at a front surface side of the substrate. After performing 10 minutes of hot-air drying at 200°C, a high-speed firing IR furnace (high-speed firing test four-chamber furnace produced by NGK Insulators, Ltd.) was used to perform firing with a peak temperature of 750°C and an in-out time of 41 seconds to obtain a conductive pattern.

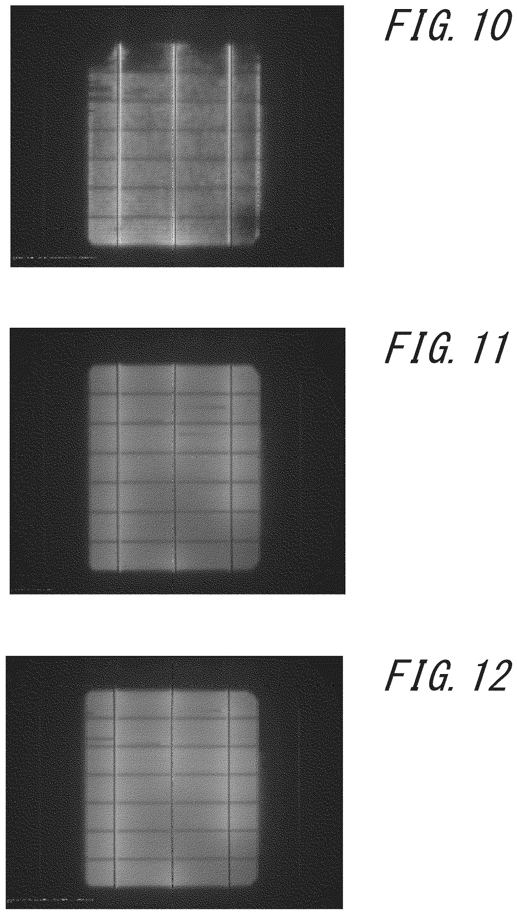

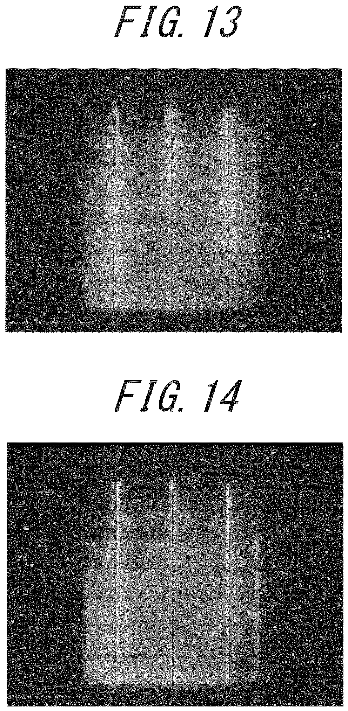

After the conductive pattern had been obtained, an EL/PL evaluation instrument (PVX330+POPLI-3C produced by ITES Co., Ltd.) was used to confirm the presence or absence of electrode disconnection. Note that in this EL/PL evaluation instrument, current was caused to flow in the busbar electrodes, and EL (electroluminescence) evaluation was performed. In a case in which there is disconnection of an electrode (finger electrode) between busbar electrodes, the position where there is disconnection appears black because light is not emitted. FIGS. 10 to 14 illustrate EL evaluation results for conductive pastes in which the silver powders of Examples 1 to 4 and Comparative Example 1 were used. It can be seen that with the conductive paste in which the silver powder of the comparative example was used, more black sections where light was not emitted were observed due to disconnection at thinner line widths, whereas the conductive pastes in which the silver powders of the examples were used enabled fine line printing to a greater extent. It can also be seen that even when the peak temperature during firing was lowered from 750°C to 710°C or 690°C, light emission was observed even at sections having a thin line width in the same manner as with a peak temperature of 750°C, and that light emission fine line printing was possible.

INDUSTRIAL APPLICABILITY

According to the present disclosure, a spherical silver powder that can bring about excellent printability when used in a conductive paste or the like is provided together with a production method and a production apparatus for this spherical silver powder.

REFERENCE SIGNS LIST

1       silver powder production apparatus
2       pipe
4a      reductant supply pipe
4b      reductant supply pipe
5       surface treatment agent supply pipe
6       complexing agent supply pipe
10      reductant addition member
11      opening
12      slit section
13      gap

**Claims**

1.  A spherical silver powder having a diameter $D_{10}$ at a volume-based cumulative value of 10%, a diameter $D_{50}$ at a volume-based cumulative value of 50%, and a diameter $D_{90}$ at a volume-based cumulative value of 90% according to laser diffraction that satisfy a formula:

$$(D_{90} - D_{10})/D_{50} < 1$$

and having a ratio ($D_{50}/D_{BET}$) of the $D_{50}$ relative to a BET diameter $D_{BET}$ of not less than 0.90 and not more than 1.20.

2.  The spherical silver powder according to claim 1, wherein the $D_{50}$ is not less than 0.2 μm and not more than 3.5 μm.

3.  The spherical silver powder according to claim 1, having a BET specific surface area of not less than 0.17 m$^2$/g and not more than 3.23 m$^2$/g.

4. The spherical silver powder according to claim 1, wherein the ratio ($D_{50}/D_{BET}$) is not less than 0.95 and not more than 1.05.

5. The spherical silver powder according to claim 1, wherein the $D_{BET}$ is not less than 0.18 $\mu$m and not more than 3.9 $\mu$m.

6. A method of producing a spherical silver powder comprising causing a silver complex solution to flow in a channel, adding a reductant into the channel at a reductant addition position partway along the channel, and causing reduction precipitation of silver powder inside the channel, wherein addition of the reductant is performed from a plurality of directions relative to the channel.

7. The method of producing a spherical silver powder according to claim 6, wherein each of the plurality of directions forms an angle of not less than 75° and not more than 105° relative to the channel.

8. The method of producing a spherical silver powder according to claim 6, wherein addition of the reductant is performed from all directions of an outer perimeter of the channel.

9. The method of producing a spherical silver powder according to claim 6, wherein addition of the reductant is performed with respect to a silver complex solution that contains a surface treatment agent.

10. The method of producing a spherical silver powder according to any one of claims 6 to 9, wherein a silver-containing solution and a complexing agent are mixed upstream of the reductant addition position in the channel to produce the silver complex solution inside the channel.

11. A spherical silver powder production apparatus that causes reduction precipitation of silver powder through addition of a reductant to a silver complex solution, comprising a pipe forming a channel for the silver complex solution, wherein a slit having an opening facing in an outward radial direction along an inner perimeter of the pipe is provided in the pipe, and a supply pipe for the reductant is connected to the slit.

12. The spherical silver powder production apparatus according to claim 11, comprising a plurality of supply pipes for the reductant, wherein at least two of the supply pipes for the reductant are connected to the slit eccentrically to one another.

13. A conductive paste comprising: the spherical silver powder according to any one of claims 1 to 5; an organic binder; and a solvent.

14. The conductive paste according to claim 13 for formation of an electrode of a solar cell.

# FIG. 1

Surface treatment agent

Reductant

Silver complex
solution

1

2

5

4a

4b

10

Silver powder-
containing liquid

Reductant

EP 4 516 431 A1

# FIG. 2A

Reductant

A

10

4a

13

B          B

2

4b

A

Reductant

## FIG. 2B

Reductant →

2

11

4a

Axial direction
of pipe 2

Opening
direction

Intersection
angle

12

13

11

← Reductant

4b

Silver complex solution

## FIG. 2C

2

12

11

13

Silver complex solution

*FIG. 3*

Silver-containing solution

Complexing agent

6

2

Surface treatment agent

5

Reductant

4a

10

4b

Reductant

1

Silver powder-containing liquid

*FIG. 4*

*FIG. 5*

*FIG. 6*

FIG. 7

FIG. 8

FIG. 9

*FIG. 10*

*FIG. 11*

*FIG. 12*

FIG. 13

FIG. 14

# INTERNATIONAL SEARCH REPORT

| International application No. |
|---|
| **PCT/JP2023/016355** |

### A. CLASSIFICATION OF SUBJECT MATTER

**B22F 9/24**(2006.01)i; **B22F 1/00**(2022.01)i; **B22F 1/103**(2022.01)i; **B22F 1/105**(2022.01)i
FI:  B22F9/24 E; B22F1/00 K; B22F1/103; B22F1/105

According to International Patent Classification (IPC) or to both national classification and IPC

### B. FIELDS SEARCHED

Minimum documentation searched (classification system followed by classification symbols)

B22F9/24; B22F1/00; B22F1/103; B22F1/105

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | JP 2011-42839 A (DOWA ELECTRONICS MATERIALS CO LTD) 03 March 2011 (2011-03-03) claims, paragraphs [0025]-[0032], [0050]-[0053], [0061]-[0094], fig. 1-2, 4, 6, 9, 11, 13, 17, 24 | 1-3, 5-10 |
| Y | | 10, 12-14 |
| X | US 2022/0055941 A1 (DAEJOO ELECTRONIC MATERIALS CO., LTD.) 24 February 2022 (2022-02-24) abstract, paragraphs [0001], [0146]-[0176] | 1-3, 5, 13-14 |
| Y | | 13-14 |
| X | JP 2012-214873 A (DOWA ELECTRONICS MATERIALS CO LTD) 08 November 2012 (2012-11-08) paragraphs [0001]-[0002], [0049]-[0085], tables 1-2 | 1-3, 5, 13-14 |
| Y | | 13-14 |
| Y | JP 2008-255378 A (MITSUBISHI MATERIALS CORP) 23 October 2008 (2008-10-23) abstract, paragraph [0016], fig. 1 | 10 |

☑ Further documents are listed in the continuation of Box C.   ☑ See patent family annex.

| | |
|---|---|
| \* Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **26 June 2023** | **11 July 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**

International application No.

**PCT/JP2023/016355**

**C.      DOCUMENTS CONSIDERED TO BE RELEVANT**

| Category* | Citation of document, with indication, where appropriate, of the relevant passages | Relevant to claim No. |
|---|---|---|
| X | JP 2005-48236 A (MITSUI MINING & SMELTING CO LTD) 24 February 2005 (2005-02-24)<br>        abstract, fig. 1 | 11 |
| Y | | 12 |
| A | WO 2019/117234 A1 (DOWA ELECTRONICS MATERIALS CO LTD) 20 June 2019 (2019-06-20)<br>        entire text, all drawings | 1-13 |

Form PCT/ISA/210 (second sheet) (January 2015)

**INTERNATIONAL SEARCH REPORT**
Information on patent family members

International application No.

**PCT/JP2023/016355**

| Patent document cited in search report | | | Publication date (day/month/year) | Patent family member(s) | | | Publication date (day/month/year) |
|---|---|---|---|---|---|---|---|
| JP | 2011-42839 | A | 03 March 2011 | (Family: none) | | | |
| US | 2022/0055941 | A1 | 24 February 2022 | WO | 2020/204450 | A1 | |
| | | | | KR | 10-2020-0114890 | A | |
| | | | | CN | 113677458 | A | |
| JP | 2012-214873 | A | 08 November 2012 | (Family: none) | | | |
| JP | 2008-255378 | A | 23 October 2008 | WO | 2008/123494 | A1 | |
| | | | | CN | 101626856 | A | |
| | | | | KR | 10-2009-0128380 | A | |
| JP | 2005-48236 | A | 24 February 2005 | US | 2008/0138238 | A1 | |
| | | | | abstract, fig. 1 | | | |
| | | | | WO | 2005/009651 | A1 | |
| | | | | CN | 1826197 | A | |
| | | | | KR | 10-2006-0035781 | A | |
| WO | 2019/117234 | A1 | 20 June 2019 | US | 2021/0162495 | A1 | |
| | | | | entire text, all drawings | | | |
| | | | | EP | 3702064 | A1 | |
| | | | | CN | 111432959 | A | |
| | | | | KR | 10-2020-0096286 | A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2005048236 A
- JP 2015045064 A
- JP 2010070793 A
- JP 2008255378 A